(19) Europäisches Patentamt

European Patent Office

Office européen des brevets

(11) **EP 1 635 405 A2**

(12) **EUROPEAN PATENT APPLICATION**

(43) Date of publication:
**15.03.2006 Bulletin 2006/11**

(51) Int Cl.:
*H01L 35/32* $^{(2006.01)}$

(21) Application number: **05291864.6**

(22) Date of filing: **08.09.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **09.09.2004 KR 2004072289**

(71) Applicant: **LG ELECTRONICS INC.**
**Seoul 150-721 (KR)**

(72) Inventors:
• **Lee, Seung-Min,**
**506-1005 Jin-San Maeul**
**Yongin-si, Gyeonggi-do (KR)**
• **Kye, Jeong-il**
**Uiwang-si**
**Gyeonggi-do (KR)**

(74) Representative: **Loisel, Bertrand**
**Cabinet Plasseraud**
**65/67 rue de la Victoire**
**75440 Paris Cedex 09 (FR)**

(54) **Thin film thermoelectric module**

(57)     Disclosed herein is a thin film thermoelectric module. the module includes high and low temperature part module substrates, unit thermoelectric devices, and lead wires. The high and low temperature part module substrates are arranged to face each other. The unit thermoelectric devices are located between the modules to transfer heat between the modules. The lead wires are connected to the electrodes of the unit thermoelectric devices. Each of the unit thermoelectric devices includes a pair of lower and upper substrates, electrodes, and a thermoelectric material. The pair of lower and upper substrates are arranged to face each other. The electrodes are formed on the upper surface of the lower substrate and the lower surface of the upper substrate. The thermoelectric material is disposed between the electrodes.

Fig. 1b

EP 1 635 405 A2

**Description**

BACKGROUND OF THE INVENTION

1. Field of the Invention

The present invention relates generally to a thin film thermoelectric module and, more particularly, to a thin film thermoelectric module, in which devices that use thin film materials are appropriately constructed so that the performance of the module is prevented from being degraded due to limitations in heat-dissipation technology, and the inherent performance of the thin film materials can be maximally realized.

2. Description of the Related Art

A thermoelectric module (device) is a device that can be used for power generation or cooling using a phenomenon in which, when a temperature difference is applied across both ends of a material having thermal electromotive properties, a potential difference is generated across the two ends due to the generated thermal electromotive force, or when current is supplied across both ends of the material through heterogeneous metals, cooling or heat generation, which depends on the direction of the current, occurs at an interface therewith.

The power generation of the thermoelectric module can be used for the production of energy, as in waste heat power generation, and can improve the efficiency of energy use of systems through power generation that uses the residual heat of a vehicle or heat generated from a fuel cell.

Meanwhile, the cooling of the thermoelectric module is a powerful alternative that can overcome the problems of environmental damage, noise, and long-term unreliability that exist in existing compressor-based cooling. However, the wide application of the cooling of the thermoelectric module has not been made because the efficiency of commercialized materials has not yet reached that of the compressor-based cooling.

Recent research results showed that, if an artificial nanoscale structure is formed in a material, the material's thermal conductivity caused by phonon could be greatly lowered[1], and, therefore, the efficiency of a thermoelectric device is greatly improved and approaches the efficiency of a compressor[2,3] . However, the aggregation of a material has not yet been successfully performed, and it is uncertain whether it will eventually be possible to achieve high performance using the aggregated material. Accordingly, the application of a thin film type material, which facilitates the forming of a nonostructure, is currently the most infallible method to improve performance.

In the thermoelectric device, a plot of the temperature difference between both ends of the device with respect to current has a parabola shape having a negative slope when the thermoelectric module is used as a cooling device.

This is expressed by Equation 1 as follows:

$$\Delta T(I) \;=\; -\frac{R}{2K}\left(1-\frac{\Pi}{R}\right)^2 \;+\; \Delta T_{MAX} \;-\; \frac{Q_{LOAD}}{K} \tag{1}$$

where $P = \alpha T$, $\alpha$ is thermoelectric power, $T$ is the temperature of a low temperature part, and $R$ and $K$ are the electric resistance and thermal conductance (the reciprocal of thermal resistance) of a material, respectively.

Furthermore, $Q_{LOAD}$ is the quantity of heat that is conveyed from the low temperature part. When this value is zero and current is $IMAX = n/R$, the maximal temperature difference between both ends of the material is $\Delta T_{MAX}$.

Accordingly, $\Delta T_{MAX} \;=\; \dfrac{\Pi^2}{2KR}$ .

Furthermore, assuming that the electrical conductivity of the material is $\sigma$ and thermal conductivity is $k$,

$$\Delta T_{MAX} \;=\; \frac{\Pi^2}{2KR} \;=\; \frac{1}{2}ZT^2 \quad \text{or} \quad \frac{\Delta T_{MAX}}{T} \;=\; \frac{1}{2}ZT \;.$$

In the above equations, $ZT \;=\; \dfrac{\alpha^2\sigma}{k}\,T$ is called a material performance index, which is a physical property value having no unit, and is determined by the physical properties of the material regardless of the sectional area or height of the material itself.

Accordingly, $\Delta T_{MAX}$ is also independent of sectional area and height.

In currently commercialized material, ZT is a little less than 1. In a device, the maximal temperature difference is between 60°C and 80°C when the high temperature part thereof is 30°C.

The most currently generalized device is produced in such a way that a single crystal material or an extruded material is diced into small sized units and the units are then assembled. In this case, the sectional area of a unit is about several mm$^2$, and the height thereof is about 1 mm. In this case, the current that generates the maximal temperature difference is about 5 A and, therefore, a high priced Direct Current (DC) power supply is required.

Meanwhile, since the maximum cooling power is attained when I = $I_{MAX}$ and $\Delta T$ = 0 in Equation 1, $Q_{LOADMZX}$ = $K\Delta T_{MAX}$. In this case, $\Delta T_{MAX}$ is independent of the sectional area and height of the material. Accordingly, when a thin film material or a thick film material thinner than several hundred microns is used, a high cooling density per unit area can be realized because the thermal resistance is low due to the low height of the material. When the height of the material is about 10 micrometers and the sectional area thereof is about 100 x 100 micrometers, cooling density as high as several hundred W/cm$^2$ can be attained.

However, in the high temperature part, correspondingly high heat generation density is formed. Unless heat that is generated from the high temperature part is removed through radiation, a phenomenon in which the temperature of the low temperature part with respect to open-air temperature is not lowered occurs even though the temperature of the high temperature part increases and, thereby, a temperature difference is generated between both ends of the thermoelectric device. Accordingly, the heat radiation of the high temperature part is very important, and determines the practical performance of an actual device.

However, since currently developed technology can implement a heat radiation density having a level of several tens of W/cm$^2$, it is necessary to reduce the occupation rate per unit area of a material to conform to the heat radiation density. If the occupation rate per unit area of the material decreases to reduce the cooling density, it is necessary to manufacture and use a device having a large area.

In current thin film manufacturing technology, the cost of manufacturing a thin film having a large area is very high. Accordingly, this may be a trivial problem in the case of a Laser Diode (LD) or a Light Emitting Diode (LED) in which the total thermal load of the low temperature part is large, but it may be a problem from the point of view of competitive power when thin film manufacturing technology is applied to products, such as refrigerators or air conditioners that have total thermal loads ranging from several tens to several hundreds of watts W.

(1) S.-M. Lee, D. Cahill, R. Venkatasubramanian, Thermal conductivity of Si-Ge superlattices, Appl. Phys. Lett. 70 (1997) 2957.

(2) Venkatasubramanian, R., Siivola, E.,Colpitts, T. & Quinn, B. Thin film thermoelectric devices with high roomtemperature figures of merit. Nature 413, 597-602 (2001).

(3) Harman, T. C., Taylor, P. J.,Walsh, M. P. & LaForge, B. E. Quantum dot superlattice thermoelectric materials and devices. Science 297, 2229-2232 (2002).

SUMMARY OF THE INVENTION

Accordingly, the present invention has been made keeping in mind the above problems occurring in the prior art, and an object of the present invention is to provide a cooling and power generation module using a thin film material.

Another object of the present invention is to provide a thin film thermoelectric module, in which a low temperature part module substrate and a high temperature part module substrate are spaced apart by a predetermined distance, and a heat shielding material is filled into grooves between the substrates, so that the performance of a module is prevented from being degraded due to limitations in heat-dissipation technology, and the inherent performance of the thin film materials can be maximally realized.

In order to accomplish the above object, the present invention provides a thin film thermoelectric module, including high and low temperature part module substrates arranged to face each other; unit thermoelectric devices located between the module substrates to transfer heat between both modules; and lead wires connected to the electrodes of the unit thermoelectric devices;

wherein each of the unit thermoelectric devices includes a pair of lower and upper substrates arranged to face each other; electrodes formed on the upper surface of the lower substrate and the lower surface of the upper substrate; and a thermoelectric material disposed between the electrodes.

Furthermore, the object of the present invention is to maintain a predetermined gap between the low temperature part module substrate and the high temperature part module substrate. This object can be achieved in the ways described below:

First, the present invention may further include upper unit module substrates, which are integrated with the low temperature part module substrate, between the low temperature part module substrate and the substrates, which are located immediately below the low temperature part module substrate.

Second, the present invention may further include lower unit module substrates, which are integrated with the high temperature part module substrate, between the high temperature part module substrate and the substrates, which are located immediately above the high temperature part module substrate.

Third, the present invention may further include upper unit module substrates, which are integrated with the low temperature part module substrate, between the low temperature part module substrate and the substrates, which are located immediately below the low temperature part module substrate; and lower unit module substrates, which are integrated with the high temperature part module substrate between the high temperature part module substrate and the substrates, which are located immediately above the high temperature part module substrate.

It is preferred that the upper and lower unit module substrates be formed in trapezoid shapes.

Furthermore, it is preferred that each of the upper and lower unit module substrates be between 1 and 2 mm in height.

Furthermore, the present invention is characterized in that heat shielding materials are filled into grooves between the upper unit module substrates and grooves between the lower unit module substrates.

It is preferred that each of the heat shielding materials be polyurethane.

BRIEF DESCRIPTION OF THE DRAWINGS

The above and other objects, features and advantages of the present invention will be more clearly understood from the following detailed description taken in conjunction with the accompanying drawings, in which:

FIG. 1A and 1B are a transverse section and a front view showing a thin film thermoelectric module with the part thereof cut away, in accordance with a first embodiment of the prevent invention;

FIG. 1C is a side view of unit thermoelectric devices according to the first embodiment of the present invention;

FIG. 2 is a front view of a thin film thermoelectric module according to a second embodiment of the present invention;

FIG. 3 is a front view of a thin film thermoelectric module according to a third embodiment of the present invention;

FIG. 4 is a front view of a thin film thermoelectric module according to a fourth embodiment of the present invention;

FIG. 5 is a front view showing a thin film thermoelectric module in which the shape of the low temperature part module substrate of FIG. 2 is changed and a heat shielding material is filled into grooves between unit thermoelectric devices that abut on the low temperature part module substrate;

FIG. 6 is a front view showing a thin film thermoelectric module in which the shape of the high temperature part module substrate of FIG. 3 is changed and a heat shielding material is filled into grooves between unit thermoelectric devices that abut on the high temperature part module substrate; and

FIG. 7 is a front view showing a thin film thermoelectric module in which the shapes of high and low temperature part module substrates of FIG. 4 are changed and heat shielding materials are filled into grooves between unit thermoelectric devices.

DESCRIPTION OF THE PREFERRED EMBODIMENTS

Preferred embodiments of the present invention are described in detail with reference to the accompanying drawings below.

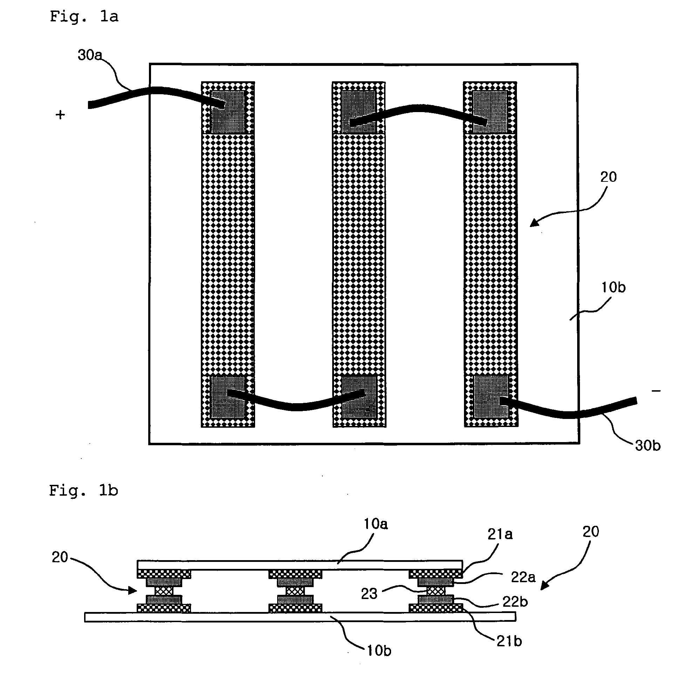

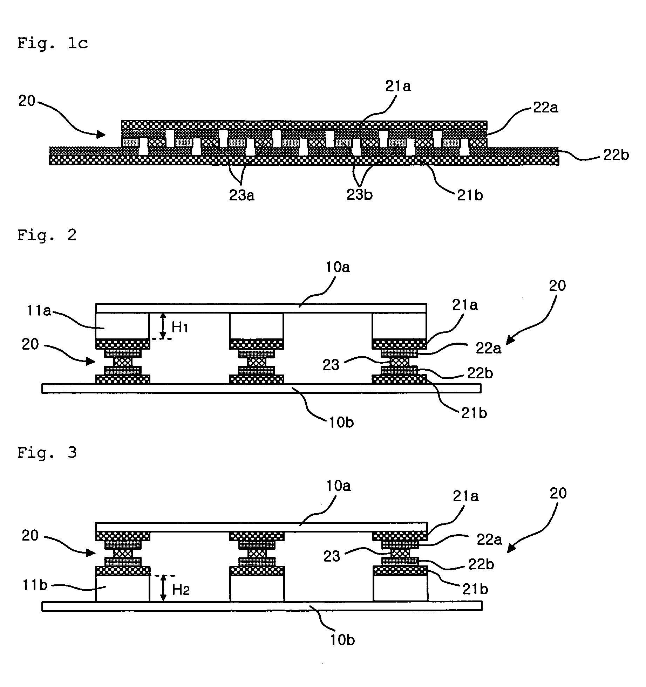

FIG. 1A and 1B are a transverse section and a front view showing a thin film thermoelectric module with the part thereof cut away, in accordance with a first embodiment of the prevent invention. Furthermore, FIG. 1C is a side view of unit thermoelectric devices according to the first embodiment of the present invention.

Referring to FIGS. 1A to 1C, the thin film thermoelectric module is formed of a high temperature part module substrate 10b, unit thermoelectric devices 20, and a low temperature part module substrate 10, which are sequentially arranged in an upward direction.

Furthermore, lead wires 30a and 30b are connected to the electrodes of the unit thermoelectric devices 20.

The low temperature part module substrate 10a is located on the upper side of the module and the high temperature part module substrate 10b is located on the lower side of the module, so that the two module substrates 10a and 10b are arranged to face each other.

Since the module substrates 10a and 10b are insulated by the substrates of the unit thermoelectric devices 20, there is no particular need to use an insulator. Accordingly, it is preferred that the module substrates 10a and 10b be made of materials such as aluminum (A1) and copper (Cu).

The unit thermoelectric devices 20, which are located between the two module substrates and transfer heat between the two module substrates, are formed of lower substrates 21b, lower electrodes 22b, thermoelectric material 23, 23a and 23b, upper electrodes 22a, and upper substrates 21a, which are sequentially arranged in an upward direction.

Although not shown in the drawings, solder layers are formed between the thermoelectric material 23 and the upper electrodes 22a.

It is preferred that the solder layers be made of tin-based material.

It is preferred that the upper and lower substrates 21a and 22b be formed of material having excellent thermal diffusion capability, the examples of which include metals, such as Si, Cu, and Al, and insulating substrates, such as AlN and BeO. Furthermore, when Si is used as the material for the upper and lower substrates 21a and 22b, insulation layers must be formed on the surfaces of the upper and lower substrates 21a and 22b because Si has electrical conductivity.

The thermoelectric material 23 are classified into N-type thermoelectric material 23a and P-type thermoelectric material 23b.

FIGS. 2 to 4 show thin film thermoelectric modules that are improved over the embodiment shown in FIGS. 1A to 1C.

FIG. 2 is a front view of a thin film thermoelectric module according to a second embodiment of the present invention.

Referring to FIG. 2, the thin film thermoelectric film of the present embodiment further includes upper unit module substrates 11a formed between a low temperature part module substrate 10a and upper substrates 21a, which are located immediately below the low temperature part module substrate 10a, in contrast to the thin film thermoelectric module shown in FIG. 1b.

It is preferred that the upper unit module substrates 11a be integrated with the low temperature part module substrate 10a.

It is preferred that the height H1 of the upper unit module substrates 11a be greater than 1 mm, and further preferred that the height be between 1 and 2 mm.

IF the height H1 of the upper unit module substrates 11a exceeds 2 mm, problems occur in that the mechanical strength gradually decreases and manufacturing cost increases.

As described above, the upper unit module substrates 11a are formed between the low temperature part module substrate 10a and the upper substrates 21a, so that the gap between the low temperature part module substrate 10a and the high temperature part module substrate 10b is wider than that of FIG. 1.

Accordingly, the present embodiment can improve the performance of the thin film thermoelectric module by preventing inverse heat conduction due to air and radiation.

FIG. 3 is a front view of a thin film thermoelectric module according to a third embodiment of the present invention.

Referring to FIG. 3, the thin film thermoelectric module of the present embodiment further include lower unit module substrates 11b formed between a high temperature part module substrate 10b and lower substrates 21b, which are located immediately above the high temperature part module substrate 10b, in contrast to the thin film thermoelectric module shown in FIG. 1b.

It is preferred that the lower unit module substrates 11b be integrated with the high temperature part module substrate 10b.

Since the lower unit module substrates 11b have the same specification (height, etc.) and characteristics as the upper unit module substrate 11a set forth in the descriptions made in conjunction with FIG. 2, a description of the lower unit module substrates 11b is omitted here.

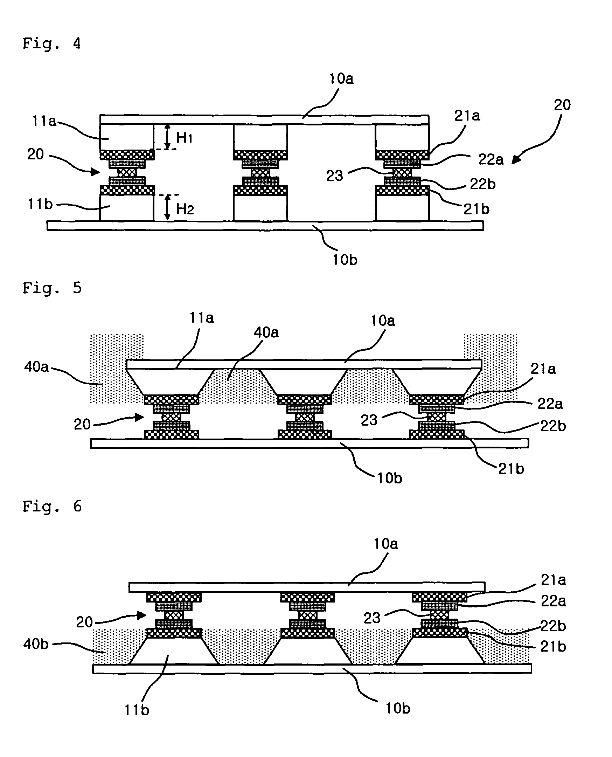

FIG. 4 is a front view of a thin film thermoelectric module according to a fourth embodiment of the present invention.

Referring to FIG. 4, the thin film thermoelectric module of the present embodiment further includes upper unit module substrates 11a formed between a low temperature part module substrate 10a and upper substrates 21a, which are located immediately below the low temperature part module substrate 10a, and lower unit module substrates 11b formed between a high temperature part module substrate 10b and lower substrates 21b, which are located immediately above the high temperature part module substrate 10b, in contrast to the thin film thermoelectric module shown in FIG. 1b.

It is preferred that the upper unit module substrates 11a and the lower unit module substrates 11b be integrated with the low temperature part module substrate 10a and the high temperature part module substrate 10b, respectively.

Since the upper unit module substrates 11a and the lower unit module substrates 11b have the same specification (height etc.) and characteristics as the upper unit module substrate 11a set forth in the description made in conjunction with FIG. 2, descriptions of the upper unit module substrates 11a and the lower unit module substrates 11b are omitted here.

FIGS. 5 to 7 show thin film thermoelectric modules that are improved over the embodiments shown in FIGS. 2 to 4.

FIG. 5 is a front view showing a thin film thermoelectric module in which the shape of the low temperature part module substrate of FIG. 2 is changed and a heat shielding material is filled into grooves between unit thermoelectric devices that abut on the low temperature part module substrate.

Referring to FIG. 5, upper unit module substrates 11a are formed in trapezoid shapes in the present embodiment.

Accordingly, the present embodiment can realize further lowering of the temperature of a lower part by reducing the thermal resistance between the unit thermoelectric device 20 and the low temperature part module substrate 10a.

Furthermore, in the present embodiment, a heat shielding material 40a is filled into grooves between upper unit module substrates 11a that abut on the low temperature part module substrate 10a.

It is preferred that the heat shielding material 40a have a lower thermal conductivity than that of air, and that it have the characteristics of preventing convection and reducing heat conduction via radiation.

The heat shielding material 40a is preferably PolyUrethane Foam (PUF).

As described above, the present invention can block heat conduction, induced by convection, in the grooves by filling the grooves with the heat shielding material 40a.

FIG. 6 is a front view showing a thin film thermoelectric module in which the shape of the high temperature part module substrate of FIG. 3 is changed and a heat shielding material is filled into grooves between unit thermoelectric devices that abut on the high temperature part module substrate.

Referring to FIG. 6, lower unit module substrates 11b are formed in trapezoid shapes in the present embodiment.

Accordingly, the present embodiment can further spread the flow of heat, which is generated from the unit thermoelectric devices 20, while improving heat shielding between two modules.

Furthermore, in the present embodiment, a heat shielding material 40b is filled into grooves between lower unit module substrates 11b that abut on the high temperature part module substrate 10b.

Since the description of the heat shielding material 40b has been made in the description made in conjunction with FIG. 5, a description of the heat shielding material 40b is omitted here.

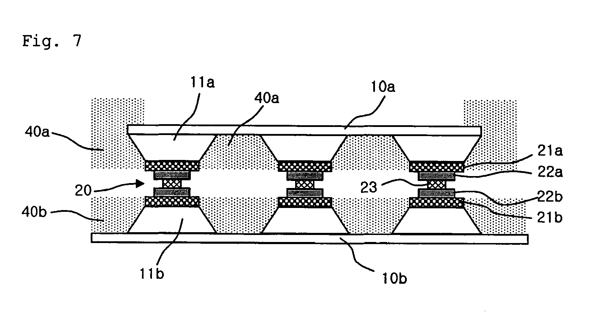

FIG. 7 is a front view showing a thin film thermoelectric module in which the shapes of high and low temperature part module substrates of FIG. 4 are changed and heat shielding materials are filled into grooves between unit thermoelectric devices.

Referring to FIG. 7, an upper unit module substrates 11a and a lower unit module substrates 11b are formed in trapezoid shapes.

Accordingly, the present embodiment can further spread the flow of heat, which is generated from the unit thermoelectric devices 20, while improving heat shielding between two modules.

Furthermore, in the present embodiment, heat shielding materials 40a and 40b are filled into grooves between lower unit module substrates 11b that abut on the high temperature part module substrate 10b, and into grooves between upper unit module substrates 11a that abut on the low temperature part module substrate 10a.

Since the descriptions of the heat shielding materials 40a and 40b have been made in the descriptions made in conjunction with FIGS. 5 and 6, descriptions of the heat shielding materials 40a and 40b are omitted.

As described above, in accordance with the present invention, a module having a wider area is manufactured using unit thermoelectric devices that are patterned at a high density through a thin film manufacturing process, so that the high performance of thin film material can be used, and the problem of high production cost per unit area, which occurs in existing thin film material, can be solved.

Although the present invention has been described with reference to the accompanying drawings with emphasis on the preferred embodiments, those skilled in the art will appreciate that various modifications, additions and substitutions are possible, without departing from the scope and spirit of the invention as disclosed in the accompanying claims.

**Claims**

1. A thin film thermoelectric module, comprising:

   a low temperature module substrate;
   a high temperature module substrate positioned under the low temperature module substrate and arranged to face the low temperature module substrate;
   one or more unit thermoelectric devices located between the high and low temperature module substrates, each of the unit thermoelectric devices comprising a thermoelectric material; and
   a power supply means configured to supply power to the unit thermoelectric devices.

2. The thin film thermoelectric module as set forth in claim 1, further comprising upper unit module substrates attached between the low temperature module substrate and the unit thermoelectric devices.

3. The thin film thermoelectric module as set forth in claim 2, wherein the unit module substrates attached to the low temperature module substrate have surfaces that are wider than surfaces of the unit module substrates attached to the unit thermoelectric devices.

4. The thin film thermoelectric module as set forth in claim 2, wherein each of the upper unit module substrates has a height between 1 and 2 mm.

5. The thin film thermoelectric module as set forth in claim 2, further comprising a heat shielding material that is interposed between the upper unit module substrates attached to the low temperature module substrate.

6. The thin film thermoelectric module as set forth in claim 5, wherein the heat shielding material is made of polyurethane.

7. The thin film thermoelectric module as set forth in claim 2, wherein the unit thermoelectric devices comprise insulation materials on surfaces thereof to which the upper unit module substrates are attached, each of the upper unit module substrates being made of one or more materials selected from a group consisting of aluminum and copper.

8. The thin film thermoelectric module as set forth in claim 1, further comprising lower unit module substrates attached between the high temperature module substrate and the unit thermoelectric devices.

9. The thin film thermoelectric module as set forth in claim 8, wherein the lower unit module substrates attached to the high temperature module substrate have surfaces that are wider than surfaces of the lower unit module substrates attached to the unit thermoelectric devices.

10. The thin film thermoelectric module as set forth in claim 8, wherein each of the lower unit module substrates has a height between 1 and 2 mm.

11. The thin film thermoelectric module as set forth in claim 8, further comprising a heat shielding material that is interposed between the lower unit module substrates attached to the high temperature module substrate.

12. The thin film thermoelectric module as set forth in claim 11, wherein the heat shielding material is made of polyurethane.

13. The thin film thermoelectric module as set forth in claim 8, wherein the unit thermoelectric devices comprise insulation materials on surfaces thereof to which the unit module substrates are attached, each of the lower unit module substrates being made of one or more materials selected from a group consisting of aluminum and copper.

14. The thin film thermoelectric module as set forth in claim 1, further comprising upper unit module substrates and lower unit module substrates that are attached between the low temperature module substrate and the unit thermoelectric devices and between the high temperature module substrate and the unit thermoelectric devices, respectively.

15. The thin film thermoelectric module as set forth in claim 14, wherein the upper unit module substrates and the lower unit module substrates respectively attached to the low temperature module substrate and the high temperature substrate have surfaces that are wider than surfaces of the upper module substrates and the lower unit module substrates respectively attached to the unit thermoelectric devices.

16. The thin film thermoelectric module as set forth in claim 14, wherein each of the upper and lower unit module substrates has a height between 1 and 2 mm.

17. The thin film thermoelectric module as set forth in claim 14, further comprising a heat shielding material that is interposed between the lower unit module substrates attached to the high temperature module substrate and between the upper unit module substrates attached to the low temperature module substrate.

18. The thin film thermoelectric module as set forth in claim 17, wherein the heat shielding material is made of polyurethane.

19. The thin film thermoelectric module as set forth in claim 14, wherein the unit thermoelectric devices comprise insulation materials on surfaces thereof to which the upper and lower unit module substrates are attached, each of the upper and lower unit module substrates being made of one or more materials selected from a group consisting of aluminum and copper.

20. The thin film thermoelectric module as set forth in claim 1, wherein each of the thermoelectric devices comprises:

an upper substrate;

a lower substrate disposed to face the upper substrate under the upper substrate;

an upper electrode attached to a lower surface of the upper substrate;

a lower electrode attached to a upper surface of the lower substrate; and

a thermoelectric material between the upper and lower electrodes.

21. The thin film thermoelectric module as set forth in claim 20, wherein the unit thermoelectric devices comprise solder layers, the solder layers being formed between the thermoelectric material and one or more electrodes selected from among the upper electrodes and the lower electrodes.

22. The thin film thermoelectric module as set forth in claim 20, wherein each of the upper and lower substrates is formed of an insulator.

23. The thin film thermoelectric module as set forth in claim 20, wherein the upper and lower substrates are made of one or more materials selected from a group consisting of silicon, copper, aluminum, aluminum nitride, and beryllium oxide.

24. The thin film thermoelectric module as set forth in claim 20, wherein the power supply means comprises lead wires connected to the upper and lower electrodes.

25. The thin film thermoelectric module as set forth in claim 20, wherein unit module substrates are attached between the low temperature module substrate and the upper substrates provided on the unit thermoelectric devices.

26. The thin film thermoelectric module as set forth in claim 25, wherein the upper unit module substrates attached to the low temperature module substrate have surfaces that are wider than surfaces of the upper unit module substrates attached to the upper substrates.

27. The thin film thermoelectric module as set forth in claim 20, wherein the lower unit module substrates are attached between the high temperature module substrate and the lower substrates provided on the unit thermoelectric devices.

28. The thin film thermoelectric module as set forth in claim 27, wherein the lower unit module substrates attached to the high temperature module substrate have surfaces that are wider than surfaces of the lower unit module substrates attached to the lower substrates.

29. The thin film thermoelectric module as set forth in claim 20, wherein the upper and lower unit module substrates are respectively attached between the low temperature module substrate and the upper substrates provided on the unit thermoelectric devices, and between the high temperature module substrate and the lower substrates provided on the unit thermoelectric devices.

30. The thin film thermoelectric module as set forth in claim 29, wherein the unit module substrates attached to the low and high temperature module substrates have surfaces that are wider than surfaces of the unit module substrates attached to the upper and lower substrates.

Fig. 1a

Fig. 1b

Fig. 1c

Fig. 2

Fig. 3

Fig. 4

Fig. 5

Fig. 6

Fig. 7